Europäisches Patentamt

European Patent Office

Office européen des brevets

(11) Veröffentlichungsnummer: **0 622 654 A2**

## (12) EUROPÄISCHE PATENTANMELDUNG

(21) Anmeldenummer: **94105818.2**

(22) Anmeldetag: **15.04.94**

(51) Int. Cl.5: **G02F 1/015**

(30) Priorität: **24.04.93 DE 4313488**

(43) Veröffentlichungstag der Anmeldung:
**02.11.94 Patentblatt 94/44**

(84) Benannte Vertragsstaaten:
**DE FR GB IT NL**

(71) Anmelder: **Alcatel SEL Aktiengesellschaft**
**Lorenzstrasse 10**
**D-70435 Stuttgart (DE)**
(84) **DE**

(71) Anmelder: **ALCATEL N.V.**
**Strawinskylaan 341,**
**(World Trade Center)**
**NL-1077 XX Amsterdam (NL)**

(84) **FR GB IT NL**

(72) Erfinder: **Zielinski, Erich,Dr.**
**Durlacher Weg 2**
**D-71686 Remseck (DE)**
Erfinder: **Weiser,Gerhard,Prof.**
**Kellerwaldstrasse 2**
**D-35043 Marburg (DE)**

(74) Vertreter: **Pechhold, Eberhard, Dipl.-Phys. et al**
**Alcatel SEL AG**
**Patent- und Lizenzwesen**
**Postfach 30 09 29**
**D-70449 Stuttgart (DE)**

(54) **Optoelektronisches Halbleiterbauelement.**

(57) Beschrieben wird ein optoelektronisches Halbleiterbauelement (1) zur Modulation eines zugeführten Lichtstrahls, wobei das optoelektronische Halbleiterbauelement eine pin-Struktur (2,3,4) aufweist. Erfindungsgemäß ist vorgesehen, daß M Halbleiterstrukturen mit einer Lokalisierung von Ladungsträgern in mindestens einer Dimension (Q1-Q20;CB1-CB10) in mindestens zwei Gruppen (G1-G10) angeordnet sind, wobei die einer Gruppe (G1-G10) zugehörigen Halbleiterstrukturen mit einer Lokalisierung von Ladungsträgern in mindestens einer Dimension (Q1-Q20;CB1-CB10) durch Barrieren (CB1-CB10) getrennt sind, die im wesentlichen Starkleiter-Übergänge zwischen den einzelnen Halbleiterstrukturen (Q1-Q20;CB1-CB10) einer jeden Gruppe (G1-G10) erlauben, und daß die einzelnen Gruppen (G1-G10) derart gekoppelte Halbleiterstrukturen (Q1-Q20;CB1-CB10) jeweils durch eine weitere Barriere (P1-P11) getrennt sind, die im wesentlichen Starkleiter-Übergänge zwischen den aktiven Schichten (Q1-Q20) der Halbleiterstrukturen (Q1-Q20;CB1-CB10) einer Gruppe (G1-G10) zu einer aktiven Schicht (Q1-Q20) einer anderen Gruppe verhindern.

FIG.1

EP 0 622 654 A2

Die Erfindung betrifft ein optoelektronisches Halbleiterbauelement zur Modulation eines zugeführten Lichtstrahls, wobei das optoelektronische Halbleiterbauelement eine pin-Struktur aufweist, in deren intrinsischer Schicht eine Anzahl von M Halbleiterstrukturen mit einer Lokalisierung von Ladungsträgern in mindestens einer Dimension in einer aktiven Schicht angeordnet sind, wobei jeweils zwei benachbarte aktive Schichten der Halbleiterstrukturen mit einer Lokalisierung von Ladungsträgern in mindestens einer Dimension durch eine Barriere getrennt sind, und wobei über eine n-dotierte und eine p-dotierte Schicht der pin-Struktur eine Steuerspannung zur Erzeugung eines elektrischen Modulationsfeldes über die M Halbleiterstrukturen mit einer Lokalisierung von Ladungsträgern in mindestens einer Dimension in den aktiven Schichten angelegbar ist.

Ein derartiges optoelektronisches Halbleiterbauelement ist bekannt und wird zur Intensitätsmodulation des dem optoelektronischen Halbleiterbauelement zugeführten Lichtstrahls eingesetzt. Als Halbleiterstrukturen mit einer Lokalisierung von Ladungsträgern in mindestens einer Dimension werden Quantenfilme verwendet, die durch entsprechende Barrieren voneinander entkoppelt sind. Zur Intensitätsmodulation des Lichtstrahls wird der quantenunterstützte Stark-Effekt ausgenützt, der bewirkt, daß unter dem Einfluß eines externen elektrischen Feldes eine Änderung des Absorptionsspektrums des optoelektronischen Halbleiterbauelements im Bereich der Absorptionskante auftritt: Die energetische Verschiebung des die Absorption im Bereich vor der Absorptionskante bestimmenden Exzitons von schwerem Loch und Elektron führt zu einer starken Abnahme der Absorption im energetischen Bereich der ursprüngliche Absorptionskante und zum Aufbau einer weiteren Absorption im Energiebereich unterhalb der Energie des o.g. Exzitons. Legt man nun die Arbeitswellenlänge des dem optoelektronischen Halbleiterbauelement zugeführten Lichtstrahl in diesen letztgenannten Bereich, so ist es möglich, durch eine Variation des über die p- und die n-Schicht des optoelektronischen Halbleiterbauelements angelegten elektrischen Feldes eine feldabhängige Intensitätsmodulation des Lichtstrahls über eine absorptive und/oder eine interferometrische Extinktion durchzuführen.

Nachteilig an dem bekannten Halbleiterbauelement ist, daß eine Vielzahl von durch entsprechende Barrieren getrennte Quantenfilme verwendet werden müssen, um einen hinreichend großen Effekt zu erzielen: Die mittels eines oder einiger weniger entkoppelter Quantenfilme erzeugbare Intensitätsänderung des eingespeisten Lichtstrahls reicht meinstens in der Praxis nicht aus. Diese erforderliche Vielzahl von Quantenfilmen bewirkt aber, daß sich die dann auch im feldfreien Zustand vorhandene Grundabsorption eines jeden einzelnen Quantenfilms in nachteiliger Art und Weise zu einer hohen Gesamt-Grundabsorption aufaddiert, so daß im feldfreien Fall eine unerwünschte Grunddämpfung des dem Halbleiterbauelement zugeführten Lichtstrahls auftritt. Desweiteren ist bei dem bekannten Halbleiterbauelement nachteilig, daß zur ausreichende Modulation des zugeführten Lichtstrahls ein hohes Modulationsfeld erforderlich ist.

Es sind auch optoelektronische Halbleiterbauelemente zur Intensitätsmodulation eines zugeführten Lichtstrahls bekannt, welche eine Vielzahl von Quantenfilmen aufweisen, die nur durch dünne Barrieren getrennt sind. Die dadurch bewirkte Koppelung der Quantenfilme resultiert in einer sog. Übergitter-Struktur, bei der infolge des quantenmechanischen Tunneleffekts eine Delokalisierung der in den Quantenfilmen konzentrierten Ladungsträger über die gesamte Übergitter-Struktur auftritt. Diese im feldfreien Fall ausgedehnten Zustände der Ladungsträger in der Übergitter-Struktur werden unter der Einwirkung eines elektrischen Felds sehr rasch auf einige wenige Quantenfilme lokalisiert (Stark-Lokalisierung): Diese durch das elektrische Feld bewirkte Lokalisierung der im feldfreien Fall über die gesamte Übergitter-Struktur delokalisierten Ladungsträger führt zu einer starken Zunahme der Absorption im Zentrum der weichen Absorptionskante des feldfreien Falls und zu einer Abnahme der Absorption im oberen und im unteren Bereich der Absorptionskante. Im niederenergetischen Spektralbereich der Absorptionsfunktion des optoelektronischen Halbleiterbauelements tritt eine Zunahme der Absorption durch die sog. Starkleiter-Übergänge auf, die sich in einer stärkeren Rotverschiebung der Absorptionskante als im Falle des quantenunterstützten Stark-Effekt manifestiert.

Nachteilig an der Stark-Lokalisierung ist, daß durch die Starkleiter-Übergänge eine Verschmierung der Absorptionskante auch im feldfreien Fall auftritt, welche wiederum zu einer unerwünschten Grunddämpfung des dem optoelektronischen Halbleiterbauelements zugeführten Lichtstrahls sowie aufgrund dieser verschmierten Verteilung der Oszillatorstärke zu einer Abnahme des zur Modulation nutzbaren Effekts führt. Durch diese nachteilige Auswirkung ist man daher gezwungen, die Arbeitswellenlänge des dem optoelektronischen Halbleiterbauelements zugeführten Lichtstrahls weit weg von der Absorptionskante zu wählen. Eine Verschiebung der Arbeitswellenlänge aus dem der Absorptionskante unmittelbar vorgelagerten energetischen Bereich zu niedrigeren Energien hin besitzt jedoch den Nachteil, daß in diesem niederenergetischen Bereich die durch das elektrische Feld bewirkte Änderung der Absorptionseigenschaften wiederum sehr rasch abnimmt.

Zur Vermeidung dieser Nachteile stellt sich die Erfindung die Aufgabe, ein optoelektronisches Halbleiterbauelement der eingangs genannten Art derart weiterzubilden, daß eine verbesserte Modulation des zugeführten Lichtstrahls erreicht wird.

Diese Aufgabe wird erfindungsgemäß dadurch gelöst, daß die M Halbleiterstrukturen mit einer Lokalisierung von Ladungsträgern in mindestens einer Dimension in mindestens zwei Gruppen angeordnet sind, wobei die einer Gruppe zugehörigen Halbleiterstrukturen mit einer Lokalisierung von Ladungsträgern in mindestens einer Dimension durch Barrieren getrennt sind, die im wesentlichen Starkleiter-Übergänge zwischen den einzelnen Halbleiterstrukturen einer jeden Gruppe erlauben, und daß die einzelnen Gruppen derart gekoppelter Halbleiterstrukturen jeweils durch eine weitere Barriere getrennt sind, die im wesentlichen Starkleiter-Übergänge zwischen den aktiven Schichten der Halbleiterstrukturen einer Gruppe zu einer aktiven Schicht einer anderen Gruppe verhindern.

Durch die erfindungsgemäßen Maßnahmen wird in vorteilhafter Art und Weise erreicht, daß die nachteiligerweise eine Verschmierung der Absorptionskante des optoelektronischen Bauelements im niederenergetischen Bereich bewirkenden Starkleiter-Übergänge über mehrere Barrieren hinweg unterdrückt werden: Die erfindungsgemäße Anordnung der M Halbleiterschichten mit einer Lokalisierung von Ladungsträgern in mindestens einer Dimension des optoelektronischen Halbleiterbauelements in mehrere entkoppelte Gruppen von gekoppelten Halbleiterstrukturen begrenzt in vorteilhafter Art und Weise die Ordnung der Starkleiter-Übergänge auf einen Wert, der im wesentlichen gleich der Anzahl der in einer entkoppelten Gruppe angeordneten Halbleiterstrukturen mit einer Lokalisierung von Ladungsträgern in mindestens einer Dimension ist. Der bei den bekannten optoelektronischen Halbleiterbauelementen mit gekoppelten Halbleiterstrukturen auftretende langwellige Ausläufer der Absorptionsfunktion wird dadurch deutlich unterdrückt, so daß in vorteilhafter Art und Weise die Grunddämpfung des dem optoelektronischen Halbleiterbauelement zugeführten Lichtstrahls drastisch reduziert wird. Die kleinere Verschmierung der Übergangsstärke führt zu einem größeren nutzbaren Effekt, so daß die Effizienz der Intensitätsmodulation deutlich verbessert wird. Durch diese effiziente Modulation ist in vorteilhafter Art und Weise außerdem eine kompakte Bauart eines das erfindungsgemäße optoelektronische Halbleiterbauelements verwendenden Intensitätsmodulators realisierbar.

Eine vorteilhafte Weiterbildung der Erfindung sieht vor, daß jeweils nur zwei oder drei gekoppelte Halbleiterstrukturen mit einer Lokalisierung von Ladungsträgern in mindestens einer Dimension zu jeweils einer von den übrigen Gruppen entkoppelten Gruppe zusammengefaßt wird. Durch diese erfindungsgemäße Maßnahme wird in vorteilhafter Art und Weise erreicht, daß die Ordnung der Starkleiter-Übergänge im wesentlichen maximal eins oder zwei beträgt. Dieser erfindungsgemäße Aufbau vermeidet in vorteilhafter Art und Weise daher in noch höheren Maße die nachteiligen langwelligen Ausläufer der Starkleiter-Übergänge höherer als zweiter Ordnung, wobei jedoch die Vorteile der Starkleiter-Übergänge selbst, nämlich ihre rasche Verschiebung unter der Wirkung eines elektrischen Felds, aber erhalten bleiben.

Weitere vorteilhafte Weiterbildungen der Erfindung ergeben sich aus den Unteransprüchen.

Weitere Einzelheiten der Erfindung sind dem Ausführungsbeispiel zu entnehmen, welches im folgenden anhand der Figuren beschrieben wird. Es zeigen:

Figur 1    einen Querschnitt durch ein Ausführungsbeispiel;

Figur 2    ein Photostrom-Spektrum im feldfreien Fall ;

Figur 3    ein Photostrom-Spektrum bei einem modulierten elektrischen Feld;

Figur 4    ein Transmissionsspektrum des zugeführten Lichtstrahls.

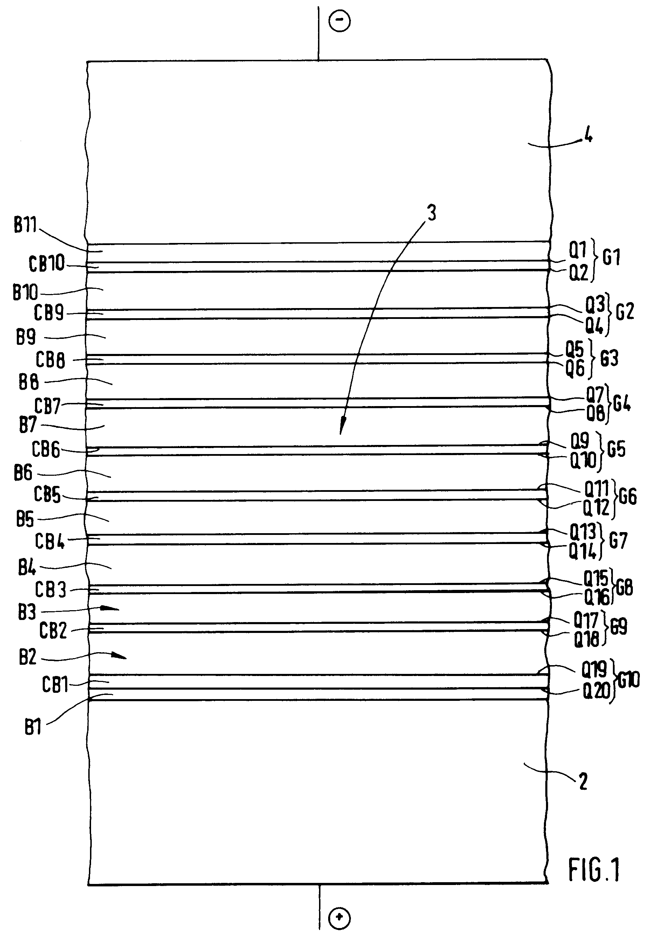

Das in Figur 1 dargestellte Ausführungsbeispiel eines optoelektronischen Halbleiterbauelements 1 zur Intensitätsmodulation eines Lichtstrahls weist eine pin-Struktur auf und gliedert sich daher prinzipiell in eine aus einem geeigneten Halbleitermaterial bestehende n-dotierte Substratschicht 2, eine intrinsische Schicht 3 und eine p-dotierte Schicht 4. Als Halbleitermaterial für das Substrat wird hierbei vorzugsweise InGaP, InP, InAs, GaAs, GaSb, AlSb oder InSb verwendet. Über die jeweils als Kontaktschicht fungierende n-dotierte Substratschicht 2 und die p-dotierte Substratschicht 4 ist ein variables Spannungspotential angelegt, so daß über die intrinische Schicht 3 ein elektrisches Feld ausgebildet wird.

In der intrinischen Schicht 3 des optoelektonischen Halbleiterbauelements sind $M = 20$ jeweils eine Halbleiterstruktur mit einer Lokalisierung von Ladungsträgern in mindestens einer Dimension Q1-Q20 ausbildende aktive Schichten angeordnet. Als Material für die aktive Schichten wird vorzugsweise InGaAs, InGaAsP, InAlGaAs, GaAs, AlGaAs oder $Al_xGa_{1-x}As_ySb_{1-y}$ verwendet. Es ist aber auch möglich, anstelle der eben genannten III-V Halbleitermaterialien, die bevorzugt bei Lichtstrahlen mit einer Wellenlänge von ca. 800-1700 nm eingesetzt werden, auch II-VI-Halbleitermaterialien zu verwenden, der bevorzugter Einsatzbereich bei Wellenlängen von ca. 400-800 nm liegt.

Die geometrische Dicke dieser vorzugsweise epitaktisch aufgebrachten aktiven Schichten beträgt hierbei einige Nanometer; sie liegt also unter der Streulänge und unter der DeBroglie-Wellenlänge der Elektronen.

Im Sinne einer prägnanten Beschreibung wird im folgenden davon ausgegangen, daß die in Figur 1 dargestellten Halbleiterstrukturen mit einer Lokalisierung von Ladungsträgern in mindestens einer Dimension Q1-Q20 als Quantenfilme ausgebildet sind, bei denen in einer zur Filmebene orthogonalen Richtung ein Ladungsträger in einer Dimension auftritt. Es ist aber auch möglich, anstelle der Quantenfilme Quantendrähte - welche eine Lokalisierung von Ladungsträgern in zwei Dimensionen ausbilden - oder Quantenpunkte mit einer Lokalisierung von Ladungsträgern in drei Dimensionen zu verwenden. Im folgenden wird im Sinne der o.g. prägnanten Beschreibung ohne Beschränkung der Allgemeinheit der anschließenden Erläuterung anstelle von "Halbleiterstrukturen mit einer Lokalisierung von Ladungsträgern in mindestens einer Dimension" nunmehr von "Quantenfilmen" gesprochen. Es wird jedoch explizit darauf hingewiesen, daß die nachstehend aufgeführten Überlegungen mutatis mutandis auch für Quantendrähte und Quantenpunkte gelten. Ebenso besitzt die in Fig. 1 gezeigte Anordnung von M = 20 Quantenfilmen Q1-Q20 nur beispielhaften Charakter. Es ist vielmehr möglich, in Abhängigkeit vom gewünschten Einsatzzweck des optoelektronischen Kalbleiterbauelements und von der Größe des zu erzielenden Effekts mehr oder weniger als zwanzig Quantenfilme Q1-Q20 vorzusehen.

Die zwanzig Quantenfilme Q1-Q20 der intrinsischen Schicht 3 sind - wie aus Figur 1 ersichtlich ist - in zehn jeweils zwei Quantenfilme Q1-Q20 aufweisenden Quantenfilm-Gruppen G1-G10 gegliedert, wobei die einzelnen Quantenfilm-Gruppen G1-G10 durch jeweils eine Barriere B1-B11 getrennt sind. Wichtig hierbei ist, daß die die einzelnen Quantenfilm-Gruppen G1-G10 mit je zwei Quantenfilmen Q1-Q20 trennenden Barrieren B1-B11 derart ausgebildet sind, daß eine Entkopplung der einzelnen Quantenfilm-Gruppen G1-G10 gewährleistet ist, d.h., daß unter dem Einfluß des über die intrinsische Schicht 3 anliegenden elektrischen Feldes zwischen den einzelnen Quantenfilm-Gruppen G1-G10 keine Starkleiter-Übergänge von Ladungsträgern möglich sind. Eine derartige Entkopplung der Quantenfilm-Gruppen G1-G10 wird vorzugsweise dadurch erreicht, daß die geometrische Dicke der Barrieren B1-B11 hinreichend groß gewählt wird, so daß die in den Quantenfilmen Q1-Q20 einer jeden Quantenfilm-Gruppe G1-G10 lokalisierten Ladungsträger nicht infolge des quantenmechanischen Tunneleffekts in eine benachbarte Quantenfilm-Gruppe G1-G10 diffundieren können. Es ist u.a. aber auch möglich, durch eine entsprechende Wahl des Barrieren-Materials eine quantenmechanische Diffusionsbewegung der Ladungsträger einer Quantenfilm-Gruppe G1-G10 in eine benachbarte Quantenfilm-Gruppe G1-G10 zu unterbinden. Wesentlich ist nur, daß die Barrieren B1-B11 hinreichend dick im quantenmechanischen Sinn sind, so daß keine oder nur eine hinreichend kleine Überlappung der quantenmechanischen Wellenfunktion der Ladungsträger einer Quantenfilm-Gruppe mit der entsprechenden Wellenfunktion der benachbarten Gruppe auftritt.

Die jeweils zwischen zwei Quantenfilmen Q1 und Q2 bzw. Q3 und Q4 bzw. Q19 und Q20 einer jeden Quantenfilm-Gruppe G1-G10 angeordneten weiteren Barrieren CB1-CB10 hingegen sind derart ausgebildet, daß die zu jeweils einer Quantenfilm-Gruppe G1-G10 gehörigen Quantenfilme gekoppelt sind, d.h., daß die Ladungsträger-Lokalisierung der einzelnen Quantenfilme Q1-Q20 aufgehoben ist, woraus im feldfreien Fall eine Delokalisierung der Ladungsträger im wesentlichen über die gesamte Länge L der durch die beiden gekoppelten Quantenfilme Q1-Q10 einer Quantenfilm-Gruppe G1-G10 ausgebildeten Übergitter-Struktur auftritt. Es ist also möglich, daß außer den Intra-Quantenfilm-Übergängen auch Inter-Quantenfilm-Übergänge, also Starkleiter-Übergänge zwischen den gekoppelten Quantenfilmen Q1-Q20 einer Quantenfilm-Gruppe G1-G10 stattfinden, wobei bei der in Fig. 1 gezeigten Anordnung im wesentlichen nur Starkleiter-Übergänge 1. Ordnung - d.h., daß Übergänge von einem Quantenfilm in den anderen Quantenfilm der Quantenfilm-Gruppe - auftreten können.

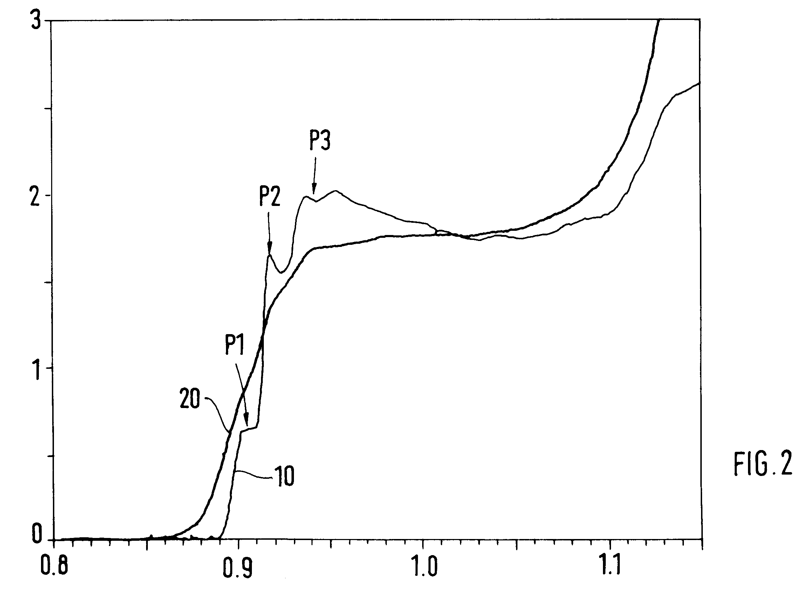

In Fig. 2 ist zur beispielhaften Erläuterung der Funktionsweise nun ein Vergleich zwischen einem Absorptionsspektrum der beschriebenen Anordnung und einer aus zwanzig gekoppelten Quantenfilmen bestehenden Übergitter-Struktur gezeigt. Hierbei ist darauf hinzuweisen, daß die geometrische Dicke der einzelnen Quantenfilme der beiden Anordnungen annähernd gleich groß gewählt wurde. Außerdem wurde die Kopplung zwischen den Quantenfilmen der Übergitter-Struktur im wesentlichen gleich groß wie die Kopplung zwischen den beiden durch eine quantenmechanisch dünne Barriere getrennten Quantenfilmen einer Quantenfilm-Gruppe gewählt.

Bei dem in der Fig. 2 enthaltenen Diagramm ist auf der Abzisse die Lichtenergie in Elektronenvolt (eV) und somit die Wellenlänge des dem optoelektronischen Bauelement zugeführten Lichtstrahls aufgetragen. Auf der Ordinate ist der gemessene Photostrom in willkürlichen Einheiten aufgetragen. Eine Photostromkurve 10 repräsentiert nun die Absorptionsfunktion, wie sie sich bei der beschriebenen, aus zehn entkoppelten Quantenfilm-Gruppen G1-G10 mit jeweils zwei gekoppelten Quantenfilmen bestehenden Anordnung ergibt. Eine Photostromkurve 20 der Fig. 2 zeigt die Absorptionsfunktion für die aus zwanzig gekoppelten Quantenfilmen bestehende Übergitter-Struktur. Man erkennt leicht den deutlich weicheren Verlauf der durch die Photostromkurve 20 repräsentierten Absorptionsfunktion, die eine Folge der elektronischen Anregungen über mehrere der quantenmechanisch dünnen Barrieren der Übergitter-Struktur hinweg, also eine Folge von Starkleiter-Übergängen von höherer als erster Ordnung, ist.

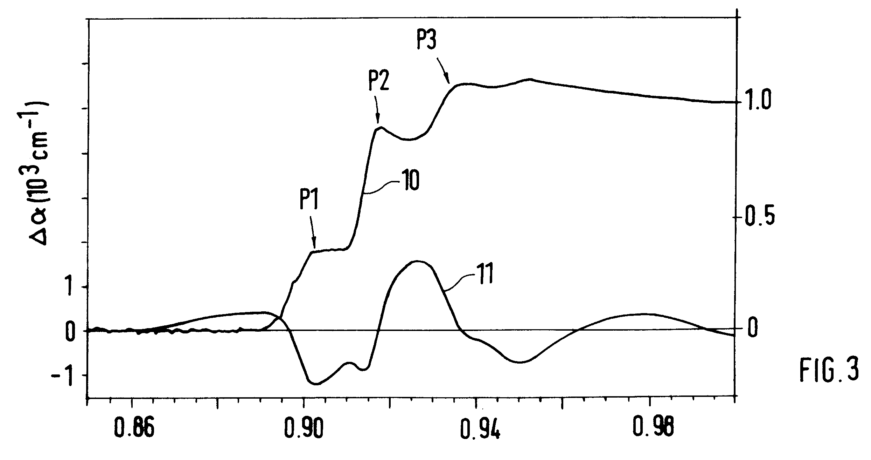

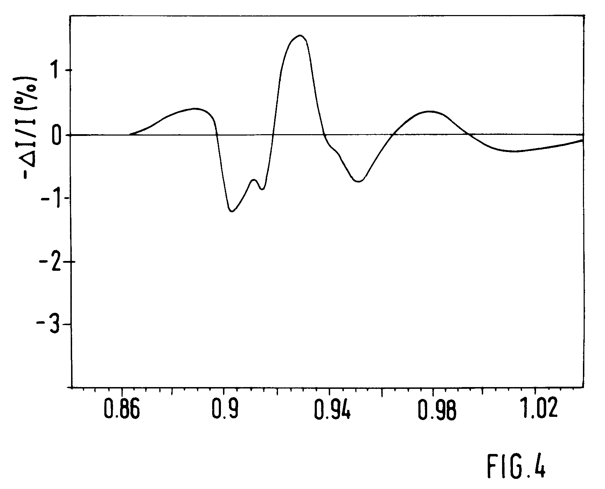

Wie die Photostromkurve 10 der Fig. 2 deutlich zeigt, tritt dieser langwellige Ausläufer im Absorptionsspektrum der beschriebenen Quantenfilm-Anordnung nicht auf, da durch die vorgesehene Anordnung der zwanzig Quantenfilme Q1-Q20 in zehn entkoppelten Quantenfilm-Gruppen G1-G10 nur Übergänge über eine Barriere, also nur über die zwischen den beiden Quantenfilmen einer Quantenfilm-Gruppe G1-G10 angeordnete Barriere CB1-CB10, möglich sind. Demzufolge treten im wesentlichen nur Starkleiter-Übergänge erster Ordnung zwischen den entkoppelten Quantenfilmen einer Quantenfilm-Gruppe auf, die sich im Photostromspektrum sowie in den weiter unten erläuterten Absorptions- bzw. Transmissionsspektrum (Fig. 3, 4) in einer Spitze P1 bei ca. 0,9 eV manifestiert. Zwei weitere Spitzen P2, P3 bei ca. 0,91 eV und 0,95 eV repräsentieren die durch den quantenunterstützten Stark-Effekt hervorgerufenen Intra-Quantenfilm-Übergänge. Außerdem erkennt man aus der stärker strukturierten Photostromkurve 10 deutlich, daß die Verteilung der Oszillatorstärke, die direkt proportional zur energetischen Verteilung der Absorptionsstärke ist, bei dem beschriebenen optoelektronischen Bauelement 1 deutlich geringer ist als bei der Photostromkurve 20, die die aus zwanzig gekoppelten Quantenfilmen bestehende Übergitter-Struktur repräsentiert.

Es ist aus dem Vergleich der beiden Photostromkurven 10 und 20 der Fig. 2 also unmittelbar entnehmbar, daß bei der beschriebenen Anordnung die durch Starkleiter-Übergänge höherer als erster Ordnung hervorgerufenen langwelligen Ausläufer der Absorption - wie sie bei der Übergitter-Struktur auftreten - nicht vorhanden sind. In vorteilhafter Art und Weise ist es daher möglich, zur Modulation des dem optoelektronischen Bauelements 1 zugeführten Lichtstrahls dessen Arbeitswellenlänge unmittelbar in dem den Starkleiter-Übergängen erster Ordnung vorgelagerten energetischen Bereich (0,88 bis 0,9 eV) - also vor die Spitze P1 - zu legen, ohne daß dabei - wie bei der Übergitter-Struktur - eine hohe störenden Grundabsorption auftritt.

In Fig. 3 ist die Photostromkurve 10 der Fig. 2 und eine die Änderung $\Delta\alpha$ des Absorptionskoeffizienten bzw. des Photostroms des optoelektronischen Bauelements 1 darstellende Differenzkurve 11 enthalten, die sich bei Anlegen eines elektrischen Modulationsfeldes (s.u.) ergibt. Hierbei wird auf der linken Ordinate der Absorptionskoeffizient in Einheiten von $10^3 cm^{-1}$ und auf der rechten Ordinate der Photostrom in willkürlichen Einheiten aufgetragen. Die Beziehung zwischen den Einheiten der linken und der rechten Ordinate wurde dabei derart gewählt, daß eine Einheit auf der rechten Ordinate in etwa $10^4 cm^{-1}$ entspricht.

In Fig. 4 ist nun die Änderung der transmittierten Intensität des dem optoelektronischen Bauelement 1 zugeführten Lichtstrahls als Funktion der Lichtenergie dargestellt, die wiederum auf der Abszisse in Einheiten von eV aufgetragen ist. Auf der Ordinate des Diagramms der Fig. 4 ist in Einheiten von Prozent der negative Quotient aus der Intensitätsänderung $\Delta I$ des transmittierten Lichtstrahls und dessen Intensität I aufgetragen, die sich bei der Modulation durch eine an die Schichten 2, 4 des beschriebenen optoelektronischen Halbleiterbauelements 1 angelegten Modulationsspannung von $\Delta U = +/-1V$ ergibt. Hierbei ist anzumerken, daß der Begriff "feldfrei" sowohl den Fall eines fehlenden externen elektrischen Modulationsfeldes als auch den Fall eines geringen externen elektrischen Modulationsfeldes, bei dem die Dämpfung des dem optoelektronischen Halbleiterbauelements 1 zugeführten Lichtstrahls für den jeweiligen Anwendungszweck vernachlässigbar ist, umfassen soll.

Man erkennt aus diesem Spektrum der modulierten Transmission - $\Delta I/I$, daß sich unter Einwirkung dieses elektrischen Modulationsfeldes im Energiebereich von ca. 0,865 bis ca. 0,88eV eine langwellige Absorption aufbaut, die im feldfreien Fall - wie aus den Photostromkurven 10 der Fig. 2 und 3 erkennbar ist, nicht vorhanden ist. In der den Verlauf der Absorptionskurve darstellenden Fig. 3 ist die Zunahme dieser Absorption unmittelbar erkennbar. Diese Zunahme der Absorption im beschriebenen Energiebereich manifestiert sich in der Fig. 4 durch den ansteigenden Verlauf der Quotientenfunktion -$\Delta I/I$, welche eine abnehmende Transmission repräsentiert.

Im Energiebereich von 0,8 eV bis ca. 0,89 eV tritt eine Umverteilung der Übergangstärke und somit der Absorptionsstärke auf, da das elektrische Modulationsfeld eine Umverteilung der Übergangsstärke zwischen den drei Spitzen P1-P3 bewirkt: Der durch den Inter-Quantenfilm-Übergang, also dem Starkleiter-Übergang zwischen zwei benachbarten Quantenfilmen einer Quantenfilm-Gruppe im Transmissions- bzw. Absorptionsspektrum hervorgerufene Spitze P1 verliert an Stärke, die den Intra-Quantenfilm-Übergängen zugute kommt.

Diese Umverteilung tritt durch die mit dem Feld zunehmende Stark-Lokalisierung der Ladungsträgerzustände auf.

Man erkennt somit aus den in den Fig. 3 und 4 enthaltenen Spektren, daß sich die beschriebene gruppierte Übergitter-Struktur in vorteilhafter Art und Weise zur Intensitätsmodulation eines dem optoelektronischen Bauelement 1 zugeführten Lichtstrahls eignet. Durch die Begrenzung der Starkleiter-Übergänge auf Übergänge erster Ordnung tritt kein durch derartige Inter-Quantenfilm-Übergänge höherer Ordnung verursachter langwelliger Absorptionausläufer im niederenergetischen Bereich auf, welcher ansonsten in unerwünschter Art und Weise zu einer nachteiligen Grundabsorption führen würde. Unter Einfluß eines elektrischen Modulationsfeldes erfolgt eine rasche Umverteilung der vor der Absorptionskante liegenden Absorptionsstärke zu kleineren Energien hin, wodurch in vorteilhafter Art und Weise eine Absorption in einem energetischen Bereich auftritt, in dem im feldfreien Fall keine derartige Absorption vorhanden ist.

Die beschriebene Anordnung der Quantenfilme im optoelektronischen Halbleiterbauelement 1 erlaubt somit in vorteilhafter Art und Weise eine feldabhängige Veränderung des Absorptionskoeffizienten, welcher über die Kramers-Kronig-Relation mit einer Änderung des Brechungsindex der Quantenfilm-Hetersstruktur für den einfallenden Lichtstrahl einhergeht. Es ist durch das beschriebene optoelektronische Bauelement somit in vorteilhafter Art und Weise möglich, einer Intensitätsmodulation des einfallenden Lichtstrahls sowohl über absorptive als auch über interferometrische Effekte zu erzielen. Diese Tatsache resultiert in einem breiten Eintrittsbereich des beschriebenen optoelektronischen Bauelements 1. Es ist möglich, daß optoelektronische Bauelement 1 in einem Absorptionsmodulator oder in einem Phasenmodulator einzusetzen. Als spezielle derartige Anwendungen sollen hier nur ein Mach-Zehner-Interferometer oder ein Richtkoppler angeführt werden.

Abschließend ist noch anzuführen, daß die beschriebene Anordnung von zwei Quantenfilmen in einer Quantenfilm-Gruppe nicht zwingend ist. Es ist auch möglich, in Abhängigkeit von dem gewünschten Einsatzzweck drei oder mehr Quantenfilme in einer Quantenfilm-Gruppe zusammenzufassen, wobei dann die zum interessierenden Teil des Absorptionsspektrums beitragenden Übergänge im wesentlichen maximal die Ordnung aufweisen, welche der Zahl der Quantenfilme einer Quantenfilm-Gruppe beträgt. Desweiteren ist es auch nicht erforderlich, daß sämtliche Quantenfilm-Gruppen G1-G10 der intrisischen Schicht 3 des optoelektronischen Bauelements 1 die gleiche Anzahl von Quantenfilmen Q1-Q20 aufweisen. Dem Fachmann ist aus der obigen Beschreibung eine Vielzahl von Möglichkeiten ersichtlich, wie er die speziell anhand des in der Fig. 1 dargestellten Ausführungsbeispiels beschriebenen Anordnung auf den gewünschten Einsatzzweck zu modifizieren hat.

**Patentansprüche**

1. Optoelektronisches Halbleiterbauelement (1) zur Modulation eines zugeführten Lichtstrahls, wobei das optoelektronische Kalbleiterbauelement eine pin-Struktur (2,3,4) aufweist, in deren intrinsischer Schicht (3) eine Anzahl von M Halbleiterstrukturen mit einer Lokalisierung von Ladungsträgern in mindestens einer Dimension in einer aktiven Schicht (Q1-Q20) angeordnet sind, wobei jeweils zwei benachbarte aktive Schichten (Q1-Q20) der Halbleiterstruktur mit einer Lokalisierung von Ladungsträgern in mindestens einer Dimension durch eine Barriere (B1-B11;CB1-CB10) getrennt sind, und wobei über eine n-dotierte und eine p-dotierte Schicht (2,4) der pin-Struktur eine Steuerspannung zur Erzeugung eines elektrischen Modulationsfeldes über die M Halbleiterstrukturen mit einer Lokalisierung von Ladungsträgern in mindestens einer Dimension in den aktiven Schichten anlegbar ist, **dadurch gekennzeichnet**, daß die M Halbleiterstrukturen mit einer Lokalisierung von Ladungsträgern in mindestens einer Dimension (Q1-Q20;CB1-CB10) in mindestens zwei Gruppen (G1-G10) angeordnet sind, wobei die einer Gruppe (G1-G10) zugehörigen Halbleiterstrukturen mit einer Lokalisierung von Ladungsträgern in mindestens einer Dimension (Q1-Q20;CB1-CB10) durch Barrieren (CB1-CB10) getrennt sind, die im wesentlichen Starkleiter-Übergänge zwischen den einzelnen Halbleiterstrukturen (Q1-Q20;CB1-CB10) einer jeden Gruppe (G1-G10) erlauben, und daß die einzelnen Gruppen (G1-G10) derart gekoppelter Halbleiterstrukturen (Q1-Q20;CB1-CB10) jeweils durch eine weitere Barriere (B1-B11) getrennt sind, die im wesentlichen Starkleiter-Übergänge zwischen den aktiven Schichten (Q1-Q20) der Halbleiterstrukturen (Q1-Q20;CB1-CB10) einer Gruppe (G1-G10) zu einer aktiven Schicht (Q1-Q20) einer anderen Gruppe verhindern.

2. Optoelektronisches Halbleiterbauelement nach Anspruch 1, dadurch gekennzeichnet, daß in mindestens einer der entkoppelten Gruppen (G1-G10) der intrinsischen Schicht (3) des optoelektronischen Halbleiterbauelements (1) nur zwei oder drei aktive Schichten (Q1-Q20) angeordnet sind.

3. Optoelektronisches Halbleiterbauelement nach Anspruch 2, dadurch gekennzeichnet, daß sämtliche Gruppen (G1-G10) der intrinsischen Schicht (3) des optoelektronischen Halbleiterbauelements (1) nur zwei oder drei aktive Schichten (Q1-Q20) enthalten.

4. Optoelektronisches Halbleiterbauelement nach Anspruch 1, dadurch gekennzeichnet, daß die geometrische Dicke der aktiven Schichten (Q1-Q20) im Nanometer-Bereich liegt.

5. Optoelektronisches Halbleiterbauelement nach Anspruch 4, dadurch gekennzeichnet, daß die aktiven Schichten (Q1-Q20) epitaktisch auf das Halbleitersubstrat (2) aufgebracht sind.

6. Optoelektronisches Halbleiterbauelement nach Anspruch 1, dadurch gekennzeichnet, daß die Arbeitswellenlänge des dem optoelektronischen Halbleiterbauelement (1) zugeführten Lichtstrahls in einem Energiebereich liegt, in dem bei einem verschwindenden oder geringem externen Modulationsfeld im wesentlichen nur eine geringe Absorption auftritt.

7. Optoelektronisches Halbleiterbauelement nach Anspruch 6, dadurch gekennzeichnet, daß die Arbeitswellenlänge des zugeführten Lichtstrahls im Energiebereich der durch die Starkleiter-Übergänge erster Ordnung hervorgerufenen Spitze (P1) eines Photostromspektrums (10) des optoelektronischen Halbleiterbauelements (1) liegt.

8. Optoelektronisches Halbleiterbauelement nach Anspruch 1, dadurch gekennzeichnet, daß die aktiven Schichten (Q1-Q20) als Quantenfilme, Quantendrähte oder Quantenpunkte ausgebildet sind.

9. Optoelektronisches Halbleiterbauelement nach Anspruch 1, dadurch gekennzeichnet, daß als Halbleitersubstrat GaP, InP, InAs, GaAs, GaSb, AlSb oder InSb verwendet wird.

10. Optoelektronisches Halbleiterbauelement nach Anspruch 1, dadurch gekennzeichnet, daß mindestens eine Schicht (Q1-Q20) aus InGaAs, InGaAsP, InAlGaAs, GaAs, AlGaAs oder $Al_xGa_{1-x}As_ySb_{1-y}$ besteht, oder daß mindestens eine Schicht (Q1-Q20) aus einem II-VI-Halbleitermaterial besteht.

11. Absorptionsmodulator, gekennzeichnet durch die Verwendung eines optoelektronischen Halbleiterbauelements (1) nach mindestens einem der Ansprüche 1 bis 10.

12. Phasenmodulator, gekennzeichnet durch die Verwendung eines optoelektronischen Halbleiterbauelements (1) nach mindestens einem der Ansprüche 1 bis 10.

FIG.1

FIG.2

EP 0 622 654 A2

FIG. 3

FIG.4